# EUROPEAN PATENT APPLICATION

(11) **EP 3 346 491 A1**
(43) Date of publication of application: **11.07.2018**
(21) Application number: 15902981.8
(22) Date of filing: 31.08.2015
(51) Int. Cl.: H01L 23/473, G06F 1/20, H05K 7/20

(54) **COOLING SYSTEM FOR ELECTRONIC DEVICE**

(71) Applicant: Exascaler Inc., Tokyo 101-0052 (JP)
(72) Inventor: INABA, Kenichi, Tokyo 101-0052 (JP); SAITO, Motoaki, Tokyo 101-0062 (JP)
(74) Representative: Goddar, Heinz J.
(86) International application number: PCT/JP2015/074814
(87) International publication number: WO 2017/037860

(57) **Abstract**

A cooling system 10 has a cooling bath 12. The open space of the cooling bath 12 contains a second coolant 13 having a boiling point T₂. In the open space of the cooling bath 12, an electronic device 100 is accommodated. The electronic device 100 has a processor 110 that is a heat generating component mounted on a board 120. The electronic device 100 is immersed in the second coolant 13 having the boiling point T₂. A boiling cooling device 200 is a cooling device thermally connected to the processor 110, and encloses a first coolant 11 having a boiling point T₁ (where T₁ = T₂ or T₁ < T₂). A first heat exchanger 22 has a high-temperature side passage and a low-temperature side passage alternately provided in separation with a wall. The high-temperature side passage is formed of a group of narrow gaps or a group of micro passages, through which the second coolant is passed. The low-temperature side passage is formed of a group of narrow gaps or a group of micro passages, through which a third cooling medium having a boiling point T₃ (where T₃ = T₂ or T₃ < T₂) is passed. A pump 40 is configured to pressurize and deliver the second coolant 13 warmed in the cooling bath 12 toward the inlet of the high-temperature side passage on the first heat exchanger 22.

## Description

### Technical Field

The present invention relates to a cooling system for an electronic device, and more specifically to a cooling system for an electronic device, the cooling system efficiently cooling an electronic device that is required to operate in ultra-high performance mode or to operate stably on supercomputers or at data centers, for example, and generates a large quantity of heat.

### Background Art

One of the biggest problems to determine the limits of performances of today's supercomputers is power consumption. The importance of studies on the energy efficiency of supercomputers is already widely recognized. That is, floating point operations per second per watt (FLOPS/Watt) is one indicator to evaluate supercomputers. At data centers, it is estimated that electric power is used for cooling by about 45 % of the power consumption in the entire data centers.
There is an increasing demand to decrease power consumption by improving cooling efficiency.

Conventionally, air cooling systems and liquid cooling systems are used for cooling supercomputers and at data centers. The liquid cooling system uses a liquid excellent in heat transfer performance much better than the heat transfer performance of air. Thus, the liquid cooling system is widely considered to be excellent in cooling efficiency. For example, in TSUBAME-KFC, which was constructed by Tokyo Institute of Technology, a liquid immersion cooling system using synthetic oil is adapted. However, synthetic oil of high viscosity is used for its coolant. Thus, this causes a difficulty of completely removing the oil attached to an electronic device after the electronic device is taken out of an oil immersion rack. This leads to a problem in that the maintenance of electronic devices is extremely difficult (specifically, adjustment, inspection, repair, replacement, and extension, for example, and hereinafter, the same meaning is applied). Moreover, a problem is reported that the synthetic oil for use corrodes a gasket and the other parts configuring the cooling system for a short time to cause leakage, resulting in a hindrance in operation.

On the other hand, a liquid immersion cooling system is proposed, which uses a fluorocarbon coolant, not synthetic oil that causes the problems described above. Specifically, the system is an example using a fluorocarbon coolant that is a hydrofluoroether (HFE) compound known as Novec 7100, Novec 7200, and Novec 7300, which are trade names of 3M Company. Novec is a trademark of 3M Company. Hereinafter, the same meaning is applied. See Patent Literature 1 and Patent Literature 2, for example.

The present applicant has already developed a small-sized liquid immersion cooling system of excellent cooling efficiency intended for small-scale immersion cooled supercomputers. The system uses a fluorocarbon coolant formed of a fully fluorinated compound. The system is applied to a small-sized supercomputer, Suiren, which is installed at High Energy Accelerator Research Organization in operation (Non- Patent Literature 1).

In order to locally cool a heat generating component, such as a CPU, which specifically generates a large quantity of heat, some examples of cooling devices are proposed, which use a boiling cooling system to transport and dissipate heat by vaporization and condensation of a coolant. One of the cooling devices is an example of a cooling module. The cooling module includes an evaporator connected to the heat generating surface of a processor and a condenser connected to an air-cooling fan or a water-cooling tube. The evaporator is connected to the condenser through two tubes for circulating a cooling medium using vapor-liquid equilibrium (Non-Patent Literature 2). Another one is an example in which a special fluid channel wall is formed in the inside of a flat plate container, the flat plate container is filled with a coolant, the heat receiving region of the flat plate container is thermally connected to a heat generating component, the heat dissipation region of the flat plate container is connected to a heat dissipation unit, such as heat dissipating fins, and the heat dissipation region forms the passage of the coolant in the heat dissipation region (e.g. Patent Literature 3).

### Citation List

### Patent Literature

Patent Literature 1: Japanese Unexamined Patent Application Publication No. 2013-187251
Patent Literature 2: Japanese Unexamined Patent Application Publication (Translation of PCT Application) No. 2012-527109
Patent Literature 3: Japanese Unexamined Patent Application Publication No. 2013-69740

Non-Patent Literature 1: "A liquid immersion cooling small-sized supercomputer, ExaScaler-1, measured the value equivalent to the world top place in the Supercomputer Green500 List for the latest supercomputers by improving performance by 25 percent or more", Press release, ExaScaler and another company, May 31, 2015, URL:http://www.exascaler.co.jp/wp-content/uploads/2015/03/20150331.pdf
Non-Patent Literature 2: Research and Development Project for Green Network/System Technology, "Research and Development of Heat-Concentrating Cooling System Using Boiling Heat Transfer (from fiscal 2008 to 2012, five years)" pp. 8-9 and 11, July 17, 2013 URL:http://www.nedo.go.jp/content/100532511.pdf

### Summary of Invention

### Technical Problem

Since the cooling system disclosed in Patent Literature 1 uses heat of vaporization (latent heat) for cooling an electronic device, a fluorocarbon coolant having a boiling point of 100 °C or less is used. The heat of an element mounted on the electronic device is removed by heat of vaporization (latent heat) when the coolant is evaporated by heat generated from the element, and thus the element is cooled. Therefore, the fluorocarbon coolant locally boils on the surface of the element at a high temperature, and the bubbles sometimes form a heat insulation film. Thus, this causes a problem in that a high thermal conduction capability, which the coolant originally posses, is degraded. Electronic devices used on modern supercomputers and at data centers, for example, include a large number of components that have to be cooled, such as a graphics processing unit (GPU), high speed storage, chip set, network unit, bus switch unit, solid state drive (SSD), and power unit (an alternating current-to-direct current converter, a direct current-to-direct current voltage converter, and any other convertor), other than a central processing unit (CPU). It is difficult to equally cool all of these components with different vaporization temperatures. Cooling efficiency becomes extremely poor in a component when the cooling medium on the surface of the component is not vaporized.

The cooling system disclosed in Patent Literature 2 adopts the configuration of a sealable module that contains one or more heat generating electronic components. Thus, this causes complexity of the overall mechanism for circulating a coolant in the individual sealable modules. Moreover, the entire electronic device is not allowed to be easily removed from the sealable module. Thus, there is a problem in that the maintenability of the electronic device is poor.

The cooling module proposed in Research and Development Project for Green Network/System Technology needs to separately provide two tubes connecting the evaporator on a processor to the condenser placed apart from the evaporator. Thus, the cooling module has a problem in that the configuration of the overall cooling module is increased in size and becomes complicated. Additionally, the presence of these tubes interferes with cooling electronic components around the processor, which have to rely on air cooling, and in secondary cooling using cooling fans or pipes, specifically in the case of using pipes, cooling efficiency remains poor because of the restrictions of flow rates in the pipes. Thus, the cooling module has a problem in that cooling performances for the overall electronic devices are restricted. On the other hand, the cooling device disclosed in Patent Literature 3 is advantageous because it can provide a small-sized boiling cooling device for local primary cooling. However, the cooling device has a problem in that cooling performances for the overall electronic devices fail to achieve improvement by the application of a previously existing secondary cooling technique of low cooling efficiency.

On the other hand, as an exemplary configuration that further improves cooling efficiency to maximize processor density per volume in a small-sized liquid immersion cooling system of excellent cooling efficiency as disclosed in Non-Patent Literature 1, the present applicant proposes a configuration in which a heat exchanger is immersed in the surface area of a coolant in a cooling bath (PCT/JP2015/069205). However, in some cases, a large-sized heat exchanger has to be used depending on types of heat exchangers, in order to transport a desired quantity of heat to the outside of the cooling bath. In such a case, a relatively large space for installing the heat exchanger has to be formed in the upper area of the cooling bath, resulting in a problem that impairs the merits of downsizing of the system. Fully fluorinated compounds that are relatively expensive are used for a coolant placed in the cooling bath and a cooling medium enclosed in the heat exchanger. Thus, upsizing the heat exchanger leads to an increase in the amounts of the coolant and the cooling medium, resulting in a problem that increases costs.

As described above, the previously existing liquid immersion cooling system has problems in that the overall mechanism for circulating the coolant through the sealable module is complicated and the maintenability of the electronic device is poor. The previously existing boiling cooling system has problems in that although the system is suited to locally cooling the electronic device, the overall mechanism is likely to be increased in size and complicated and cooling performances for the overall electronic device fail to achieve improvement because the cooling efficiency of secondary cooling is poor.

In order to further improve cooling efficiency to maximize processor density per volume, the small-sized liquid immersion cooling system of excellent cooling efficiency has the problems to be solved as described above.

Therefore, an object of the present invention is to provide a simple, efficient cooling system that solves the problems and further improves cooling performances for an electronic device.

### Solution to Problem

In order to solve the problems, an aspect of the present invention provides a cooling system that immerses an electronic device in a coolant for directly cooling the electronic device, the system including: a boiling cooling device thermally connected to at least one heat generating component of an electronic device, the boiling cooling device enclosing a first coolant having a boiling point T₁; a cooling bath containing a second coolant having a boiling point T₂ (T₂ = T₁ or T₂ > T₁) equal to the boiling point T₁ of the first coolant or higher than the boiling point T₁ of the first coolant, the boiling cooling device and the electronic device being immersed in the second coolant and directly cooled in the cooling bath; a first heat exchanger having a high-temperature side passage and a low-temperature side passage alternately provided in separation with a wall, the high-temperature side passage being formed of a group of narrow gaps or a group of micro passages, the high-temperature side passage through which the second coolant is passed, the low-temperature side passage being formed of a group of narrow gaps or a group of micro passages, the low-temperature side passage through which a third cooling medium is passed, the third cooling medium having a boiling point T₃ (T₃ = T₂ or T₃ < T₂) equal to the boiling point T₂ of the second coolant or lower than the boiling point T₂ of the second coolant, the first heat exchanger being configured to conduct heat from the second coolant to the third cooling medium; and a pump configured to pressurize and deliver the second coolant warmed in the cooling bath toward an inlet of the high-temperature side passage on the first heat exchanger.

In a preferred embodiment of the cooling system according to the present invention, a configuration may be provided in which the boiling cooling device includes a closed container having a heat receiving part and a heat dissipating part and a heat dissipation member provided on the heat dissipating part, and when the boiling cooling device and the electronic device are immersed in the second coolant, the boiling cooling device is thermally connected to the heat generating component so that the heat dissipating part is located above the heat receiving part.

In a preferred embodiment of the cooling system according to the present invention, a configuration may be provided in which the boiling point of the first coolant is a temperature of 100 °C or less, the boiling point of the second coolant is a temperature of 150 °C or more, and the boiling point of the third cooling medium is a temperature of 50 °C or less.

In a preferred embodiment of the cooling system according to the present invention, a configuration may be provided in which the first coolant and/or the third cooling medium include a fluorocarbon compound as a main component.

In a preferred embodiment of the cooling system according to the present invention, a configuration may be provided in which the second coolant includes a fully fluorinated compound as a main component.

In a preferred embodiment of the cooling system according to the present invention, a configuration may be provided in which the first heat exchanger is a plate heat exchanger or a micro channel heat exchanger.

In a preferred embodiment of the cooling system according to the present invention, a configuration may be provided in which the cooling system further includes a second heat exchanger disposed on an outside of the cooling bath, the second heat exchanger being configured to cool the third cooling medium, and an inlet and an outlet of the low-temperature side passage on the first heat exchanger are coupled to the second heat exchanger through a first circulation path.

In a preferred embodiment of the cooling system according to the present invention, a configuration may be provided in which the cooling system further includes a third heat exchanger disposed on an outside of the cooling bath, the third heat exchanger being configured to cool the second coolant, and an inlet and an outlet of the second coolant of the cooling bath, the inlet and an outlet of the high-temperature side passage on the first heat exchanger, the pump, and the third heat exchanger are coupled to each other through a second circulation path.

In a preferred embodiment of the cooling system according to the present invention, a configuration may be provided in which the cooling bath has a top plate detachably or openably mounted on the upper area of cooling bath opening, and the top plate is configured to hold the first heat exchanger.

Additionally, another aspect of the present invention provides a cooling system that immerses a plurality of electronic devices in a coolant for directly cooling the plurality of electronic devices, the system including: a cooling bath having an open space formed by a bottom plate and side walls; a plurality of accommodating sections in an array formed by dividing the open space with a plurality of inner barrier plates provided in the cooling bath, the accommodating section being configured to accommodate at least one electronic device; and an inflow opening and an outflow opening for a coolant, the inflow opening and the outflow opening being formed on each of the plurality of accommodating sections, the inflow opening being formed on a bottom part or a side surface of each of the accommodating sections, the outflow opening being formed near a liquid level of the coolant circulating the accommodating sections. The cooling system further includes: a boiling cooling device thermally connected to at least one heat generating component of an electronic device, the boiling cooling device enclosing a first coolant having a boiling point T₁; a first heat exchanger having a high-temperature side passage and a low-temperature side passage alternately provided in separation with a wall, the high-temperature side passage being formed of a group of narrow gaps or a group of micro passages, the high-temperature side passage through which a second coolant is passed, the second coolant having a boiling point T₂ (T₂ = T₁ or T₂ > T₁) equal to the boiling point T₁ of the first coolant or higher than the boiling point T₁ of the first coolant, the low-temperature side passage being formed of a group of narrow gaps or a group of micro passages, the low-temperature side passage through which a third cooling medium is passed, the third cooling medium having a boiling point T₃ (T₃ = T₂ or T₃ < T₂) equal to the boiling point T₂ of the second coolant or lower than the boiling point T₂ of the second coolant, the first heat exchanger being configured to conduct heat from the second coolant to the third cooling medium; and a pump configured to pressurize and deliver the second coolant warmed in the cooling bath toward an inlet of the high-temperature side passage on the first heat exchanger. In each of the plurality of accommodating sections, the boiling cooling device and the at least one electronic device are immersed in the second coolant in the accommodating sections for directly cooling the boiling cooling device and the at least one electronic device.

### Advantageous Effects of Invention

According to the cooling system of the present invention, the boiling cooling device locally and strongly removes heat from the heat generating component by the vaporization of the first coolant enclosed in the boiling cooling device thermally connected to the heat generating component. At the same time, the second coolant having the boiling point T₂ higher than the boiling point T₁ of the first coolant completely removes the heat from the boiling cooling device. Thus, the overall electronic device is cooled. In the cooling, the second coolant having a boiling point equal to or higher than the boiling point of the first coolant effectively and strongly cools the peripheral electronic components mounted on the electronic device. That is, the cooling medium for secondary cooling (the second coolant) used for boiling cooling the processor, which is a major heat generating source, also functions as a cooling medium for effective primary cooling of the peripheral electronic components. The first heat exchanger has the high-temperature side passage and the low-temperature side passage alternately provided in separation with a wall, the high-temperature side passage being formed of a group of narrow gaps or a group of micro passages, the high-temperature side passage through which the second coolant is passed, the second coolant having the boiling point T₂ (T₂ = T₁ or T₂ > T₁) equal to the boiling point T₁ of the first coolant or higher than the boiling point T₁ of the first coolant, the low-temperature side passage being formed of a group of narrow gaps or a group of micro passages, the low-temperature side passage through which the third cooling medium is passed, the third cooling medium having the boiling point T₃ (T₃ = T₂ or T₃ < T₂) equal to the boiling point T₂ of the second coolant or lower than the boiling point T₂ of the second coolant. Since the first heat exchanger conducts heat from the second coolant to the third cooling medium, the first heat exchanger efficiently removes heat from the second coolant. In this manner, triple cooling is performed, including the local cooling of the major heat generating source by the boiling cooling device, the overall liquid immersion cooling of the boiling cooling device and the peripheral electronic components, and the heat removal of the cooling medium for secondary cooling by the first heat exchanger. Consequently, cooling performances for the electronic device can be significantly improved. Since a coolant having a relatively high boiling point can be used for the second coolant, the second coolant is less prone to be evaporated, and the cooling bath to contain the second coolant may have an unclosed open space. Thus, this eliminates the necessity of providing a complicated, expensive closing structure. Additionally, the first heat exchanger has the high-temperature side passage formed of a group of narrow gaps or a group of micro passages and the low-temperature side passage formed of a group of narrow gaps or a group of micro passages alternately provided in separation with a wall. The heat exchanger having such a configuration (typically, a plate heat exchanger or a micro channel heat exchanger) has a pressure drop larger than a pressure drop in a typical heat exchanger (e.g. a multitubular heat exchanger including a shell-and-tube heat exchanger), whereas the heat exchanger can obtain high heat transfer performance in a compact size. That is, with the provision of the first heat exchanger in a small size and the pump in a small size configured to pressurize and deliver the cooling medium against a pressure drop in the first heat exchanger, the heat exchange between the third cooling medium and the cooling medium for secondary cooling (the second coolant) enables effective heat removal of the cooling medium for secondary cooling, and the volume occupied by a minimum necessary amount of components is small. Accordingly, the simplification and downsizing of the cooling system are achieved. The first heat exchanger is a small-sized heat exchanger that passes the cooling medium through the passage formed of a group of narrow gaps or a group of micro passages. Thus, a large amount of an expensive cooling medium is unnecessary, and a reduction in cost is enabled.

Furthermore, in the previously existing boiling cooling system, mechanisms, such as complicated tubes and a large-sized heat sink, are required for cooling the processor that is a major heat generating source. The presence of these mechanisms inevitably interferes with cooling the peripheral electronic components that have to rely on air cooling. Contrary to such previously existing techniques, in accordance with the present invention, complicated tubes and a large-sized heat sink are eliminated, which is advantageous for cooling the peripheral electronic components. Moreover, the cooling medium for secondary cooling (the second coolant) is circulated throughout the overall board of the electronic device. Thus, the peripheral electronic components can be highly efficiently cooled. Note that, in the present specification, the cooling bath with "the open space" also includes cooling baths with a simple closed structure to the extent that the serviceability of the electronic device is not degraded. For example, a structure in which a top plate is detachably or openably mounted on the opening of a cooling bath through a gasket, for example, can be a simple closed structure. Specifically, since the first heat exchanger only has to be a small-sized, lightweight heat exchanger, the first heat exchanger is mechanically holdable on the top plate.

The object and advantages of the present invention described above and other objects and advantages will be more clearly appreciated through the description of an embodiment below. Of course, the embodiments described below are Examples, which do not limit the present invention.

### Brief Description of Drawings

Figure 1 is an enlarged vertical cross sectional view of the configuration of the main components of a cooling system according to an embodiment of the present invention.
Figure 2A is a perspective view of an exemplary boiling cooling device.
Figure 2B is a perspective view of another exemplary boiling cooling device.
Figure 2C is a perspective view of another exemplary boiling cooling device.
Figure 3 is an exploded perspective view of an exemplary first heat exchanger.
Figure 4 is a cross sectional view of another exemplary first heat exchanger.
Figure 5 is a schematic view of the cooling system according to an embodiment of the present invention.
Figure 6 is a schematic view of a cooling system according to an exemplary modification of an embodiment of the present invention.
Figure 7 is a perspective view of a partially cross section illustrating the configuration of a high-density cooling system according to another embodiment of the present invention.
Figure 8 is a perspective view of the main components of the high-density cooling system according to another embodiment of the present invention.
Figure 9 is a schematic view of an exemplary installation of the first heat exchanger of the high-density cooling system according to another embodiment of the present invention.

### Description of Embodiments

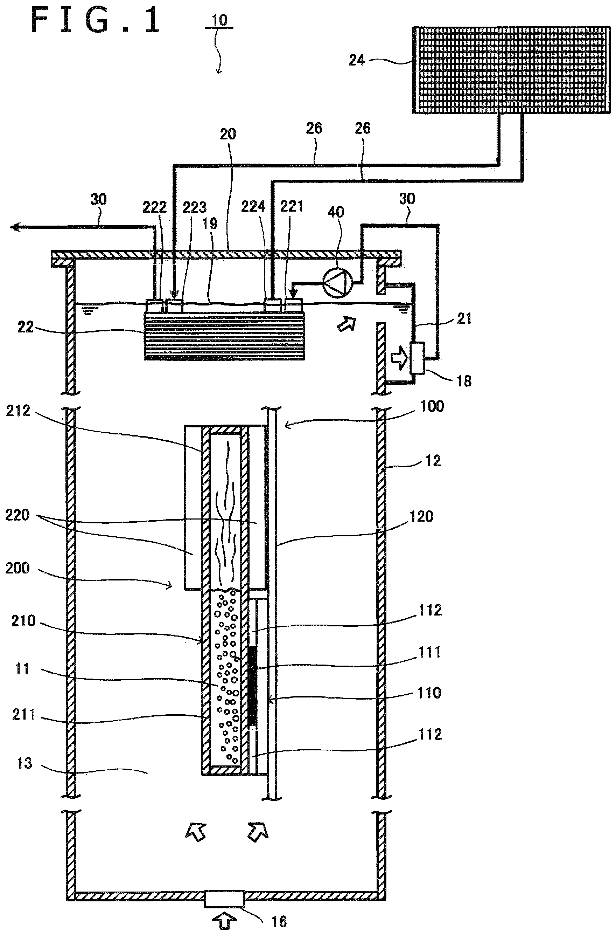

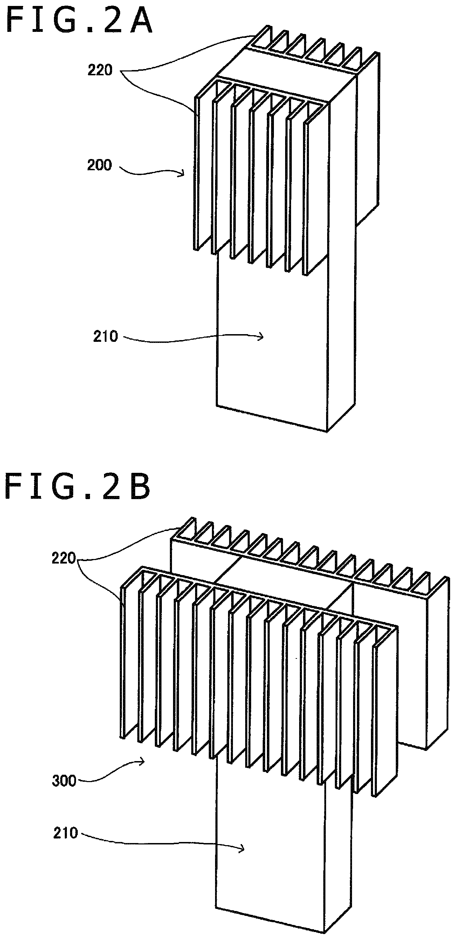

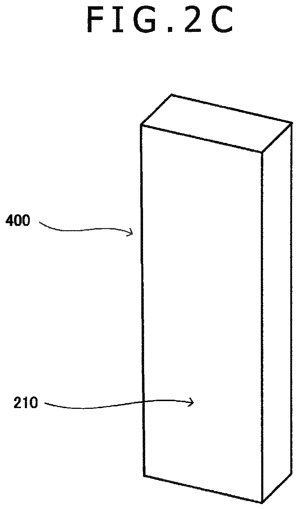

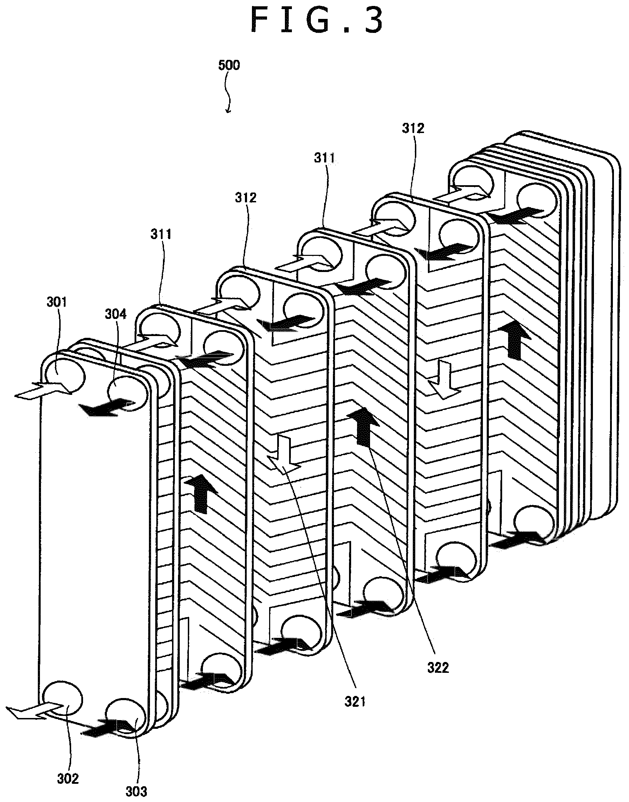

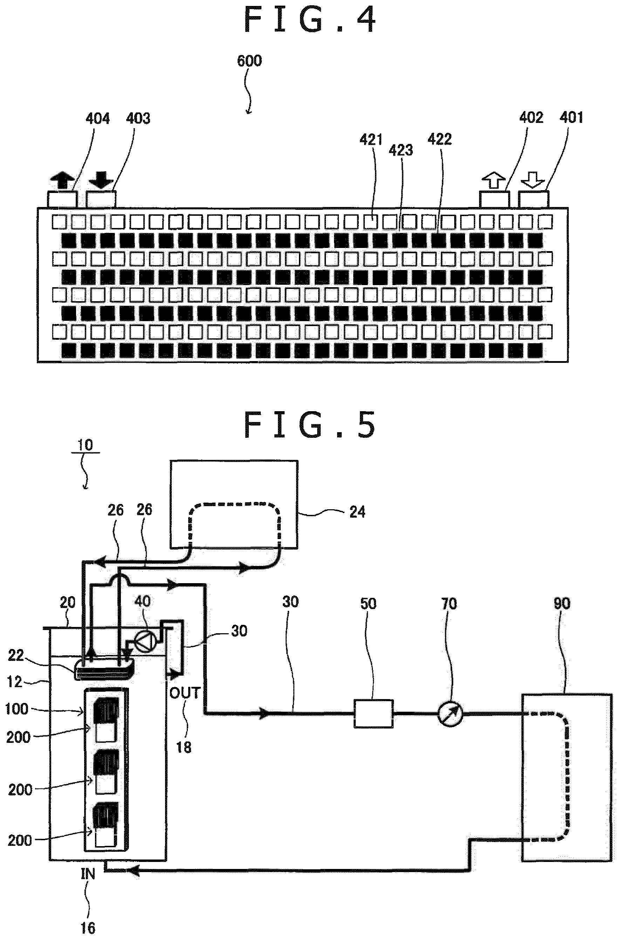

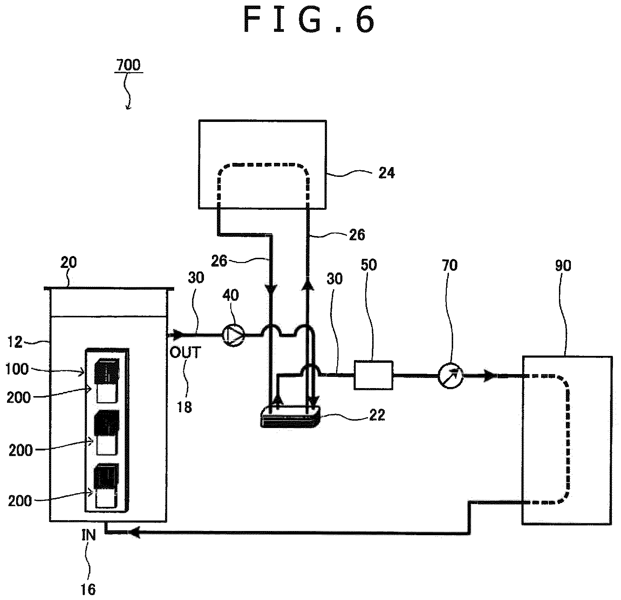

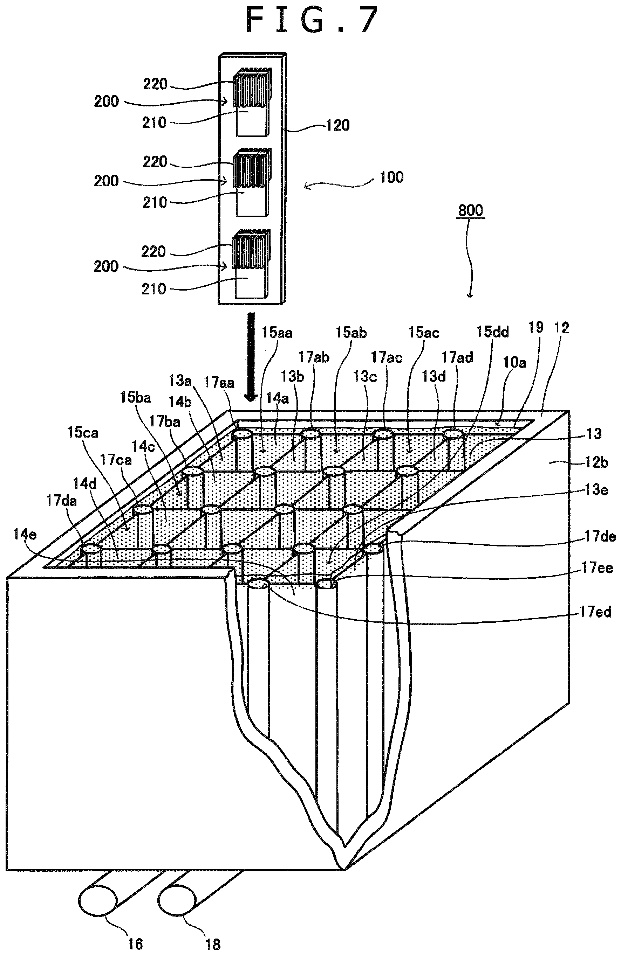

In the following, preferred embodiments of a cooling system according to the present invention will be described in detail with reference to the drawings. In the description of the embodiments, first, the configuration of the main components of a cooling system according to a preferred embodiment will be described with reference to FIGS. 1, 2A, 2B, and 2C. In the system, an electronic device having a processor, which is a heat generating component, mounted on a board is accommodated in a cooling bath for cooling. The processor includes a die (a semiconductor chip) and a heat spreader surrounding the die. Subsequently, referring to FIGS. 3 and 4, a preferred exemplary configuration of a first heat exchanger will be described. Subsequently, referring to FIG. 5, the overall structure of the cooling system according to a preferred embodiment will be described, while only one unit, as an electronic device, including a board mounted with a plurality of processors is schematically shown. The cooling system accommodates the electronic device in the cooling bath for cooling. The exemplary modification of this embodiment will be described with reference to FIG. 6. Subsequently, referring to FIGS. 7 to 9, the configuration of a high-density cooling system according to another preferred embodiment will be described. The high-density cooling system accommodates electronic devices individually in a plurality of accommodating sections formed in a cooling bath. Note that, these are only examples. The number of processors per board and a type (a CPU or GPU) of processor can be any numbers and any types. The number of units of electronic devices in the cooling system can also be any numbers. These do not limit the configuration of the electronic device according to the present invention.

Referring to FIG. 1, a cooling system 10 includes a cooling bath 12. In the open space of the cooling bath 12, a second coolant 13 having a boiling point T₂ is contained. In the open space of the cooling bath 12, an electronic device 100 is accommodated, on which a processor 110 is mounted as a heat generating component on a board 120. The electronic device 100 is immersed in the second coolant 13. The processor 110 includes a die 111 and a heat spreader 112 surrounding the die. Note that, the use of the heat spreader is an option, which may be omitted. Of course, a plurality of other processors other than the processor 110 and peripheral electronic components are mounted on the board 120 of the electronic device 100. However, the plurality of other processors and these electronic components are omitted in FIG. 1. A boiling cooling device 200 is a cooling device thermally connected to the processor 110 that is a heat generating component. The boiling cooling device 200 encloses a first coolant 11 having a boiling point T₁ (where T₁ = T₂ or T₁ < T₂).

As shown in FIGS. 1 and 2A, the boiling cooling device 200 includes a closed container 210 having a heat receiving part 211 and a heat dissipating part 212, and a heat dissipation member 220 provided on the heat dissipating part 212. In the example shown in FIGS. 1 and 2A, the closed container 210 has a thin box shape formed of six plates. These plates form a space in a rectangular cross section. Note that, the outer and inner structures of the closed container 210 are options. The dimensions and the shape may be appropriately determined taking into account of the area of the heat dissipation surface of an object to be cooled and the quantity of heat to be generated. For convenience, in the embodiment, the lower half of the closed container 210 in a box shape is referred to as the heat receiving part 211, and the upper half is referred to as the heat dissipating part 212. However, as described later, note that only one face of the lower half of the closed container 210 is connected to the heat generating surface of the processor 110. For the material of the closed container 210, metals of excellent thermal conductivity, such as aluminum, copper, and silver, can be used, but the materials are not limited to these metals.

In the closed container 210, the first coolant 11 is enclosed in an amount to the extent that the space of the heat receiving part 211 is filled with the first coolant 11. For the first coolant, a hydrofluoroether (HFE) compound can be preferably used, which is known as Novec 7000 having a boiling point of 34 °C, Novec 7100 having a boiling point of 61 °C, Novec 7200 having a boiling point of 76 °C, and Novec 7300 having a boiling point of 98 °C. Novec 700, Novec 7100, Novec 7200, and Novec 7300 are trade names of 3M Company. Novec is the trademark of 3M Company. Hereinafter, the same meaning is applied. However, the material of the first coolant is not limited to these materials. Commonly, it is desirable to manage the operating temperature of the processor at a temperature of 100 °C or less. From this concept, preferably, a coolant having a boiling point of 100 °C or less is used so that the boiling cooling function of the boiling cooling device 200 is not lost. Note that, publicly known methods are applicable to the method of enclosing the first coolant in the closed container 210, and the detailed description is omitted here.

On the heat receiving part 211 of the closed container 210, the back face of the closed container 210 in a box shape is thermally connected to the heat generating surface of the processor 110. For the connection, adhesives of excellent thermal conductivity, such as metal grease, can be used. However, materials for the connection are not limited to these adhesives. Note that, in terms of the orientation of the boiling cooling device 200 when the boiling cooling device 200 is connected to the heat generating surface of the processor 110, the boiling cooling device 200 only has to be directed to the heat generating surface so that the heat dissipating part 212 is located above the heat receiving part 211 when the boiling cooling device 200 and the electronic device 100 are immersed in the second coolant 13.

On the heat dissipating part 212 of the closed container 210, a heat dissipation member (heat dissipating fins) 220 is provided both on the front face and the back face of the closed container 210 in a box shape. The heat dissipation member 220 can manage the quantity of heat removed by the second coolant by increasing and decreasing the surface area of the heat dissipating part 212. The material of the heat dissipation member 220 may be a material similar to the material of the closed container 210. For a method of fixing the heat dissipation member 220 to the closed container, a publicly known method, such as brazing, may be used.

FIG. 2B is another example of the boiling cooling device. Components similar to the components of FIG. 2A are designated similar reference numerals and signs. In the example shown in FIG. 2B, in a boiling cooling device 300, the size of the heat dissipation member 220 is increased in the width direction, and the number of fins is increased. Thus, the quantity of heat to be dissipated is increased more than in the boiling cooling device 200 shown in FIG. 2A. Conversely, when desired cooling performances can be obtained because of advanced material technology of the closed container 210 in future without increasing the surface area by additionally providing the heat dissipation member 220, the additional provision of the heat dissipation member 220 may be omitted. That is, as still another example shown in FIG. 2C, a boiling cooling device 400 may be configured only of a closed container 210 with no heat dissipation member.

Again referring to FIG. 1, the cooling bath 12 contains the second coolant 13 to a liquid level 19 in an amount enough to entirely immerse the boiling cooling device 200 and the electronic device 100. For the second coolant, a fluorine inert fluid made of a fully fluorinated compound (a perfluorocarbon compound) can be preferably used, which is known as Fluorinert FC-72 having a boiling point of 56 °C, Fluorinert FC-770 having a boiling point of 95 °C, Fluorinert FC-3283 having a boiling point of 128 °C, Fluorinert FC-40 having a boiling point of 155 °C, and Fluorinert FC-43 having a boiling point of 174 °C. Fluorinert FC-72, Fluorinert FC-770, Fluorinert FC-3283, Fluorinert FC-40, and Fluorinert FC-43 are trade names of 3M Company. Fluorinert is a trademark of 3M Company. Hereinafter, the same meaning is applied. However, the material of the second coolant is not limited to these materials. The importance is to select a cooling medium having the boiling point T₂ higher than the boiling point T₁ of the first coolant 11 for the second coolant 13 according to the present invention. For an example, in the case in which Novec 7000 having a boiling point of 34 °C is used for the first coolant 11, Fluorinert FC-43 having a boiling point of 174 °C can be preferably used for the second coolant 13.

The present applicant focused attention on a fully fluorinated compound because the fully fluorinated compound is a compound of excellent properties, such as high electrical insulation properties, a high heat transfer capacity, being inert, being thermally and chemically stable, being nonflammable, and being free from oxygen, allowing zero ozone depletion potential. The inventor completed the invention of a cooling system using a coolant containing a fully fluorinated compound as a main component for a cooling medium for liquid immersion cooling of electronic devices packed in high density, a patent application of which was filed (Japanese Patent Application Laid-Open Publication No. 2014-170616). As disclosed in the senior application, when Fluorinert FC-43 or FC-40 is specifically used for the second coolant, a plurality of electronic devices disposed in high density in the cooling bath with a small volume can be efficiently cooled with a great decrease in a loss of the second coolant 13 from the cooling bath having an open space due to evaporation, which is significantly advantageous. However, as already described, in accordance with the present invention, of course, no limitation is imposed on the selection of any one of Fluorinert FC-72, FC-770, or FC-3283 for a coolant having the boiling point T₂ higher than the boiling point T₁ of the first coolant 11.

Note that, Fluorinert FC-43 or FC-40 has a boiling point of 150 °C or more, which is far less prone to be evaporated. Thus, a top plate 20 provided on the upper opening of the cooling bath 12 only has to be detachably or openably mounted on the upper opening for easy access to the electronic device 100 for maintenance. For example, the top plate 20 only has to be openably supported by a hinge, not shown, provided on one of the edges of the upper opening of the cooling bath 12. On the bottom part of the cooling bath 12, an inlet 16 is provided, into which the second coolant flows. On the upper part of the side part of the cooling bath 12, an outlet 18 is provided, from which the second coolant flows out through a coolant guide plate 21. Thus, the electronic device 100 accommodated in the open space of the cooling bath 12 is immersed in the second coolant 13 circulated in the open space of the cooling bath 12, and the electronic device 100 is directly cooled. Note that, alternatively or additionally, the inlet 16, into which the second coolant 13 flows, may be provided on the lower part of the side part of the cooling bath 12.

Referring to FIG. 1, the cooling system 10 according to the embodiment further has a first heat exchanger 22 mechanically held on the top plate 20. Here, an example is shown in which the first heat exchanger 22 is immersed in the surface area of the second coolant 13. However, the first heat exchanger 22 may be placed in the space above a liquid level 19. As a non-limiting mechanical holding method for the first heat exchanger 22, a suspension member (not shown) fixed on the top plate 20, for example, may be used.

In accordance with the present invention, the first heat exchanger 22 has a high-temperature side passage and a low-temperature side passage alternately provided in separation with a wall. The high-temperature side passage is formed of a group of narrow gaps or a group of micro passages through which the second coolant 13 having the boiling point T₂ (T₂ = T₁ or T₂ > T₁) is passed. The low-temperature side passage is formed of a group of narrow gaps or a group of micro passages through which a third cooling medium is passed. The third cooling medium has a boiling point T₃ (T₃ = T₂ or T₃ < T₂) equal to the boiling point T₂ of the second coolant or lower than the boiling point T₂ of the second coolant 13. A high-temperature fluid (the second coolant 13 of the present invention) entered from an inlet 221 of the high-temperature side passage is passed through the high-temperature side passage, and discharged from an outlet 222 of the high-temperature side passage. On the other hand, a low-temperature fluid (the third cooling medium of the present invention) entered from an inlet 223 of the low-temperature side passage is passed through the low-temperature side passage, and discharged from the outlet 224 of the low-temperature side passage. As the first heat exchanger having this configuration, a plate heat exchanger and a micro channel heat exchanger respectively shown in FIGS. 3 and 4 can be preferably applied, for example, which are non-limiting examples.

FIG. 3 is a first heat exchanger 500, to which a plate heat exchanger is applied as an example. The plate heat exchanger is configured in which two types of heat transfer plates 311 and 312 have irregular patterns, which are different from each other and typically formed by providing various projections or grooves, formed on their surfaces, and the heat transfer plates 311 and 312 are alternately laid in multiple plates and integrated with one another with a brazing filler metal (or by bolting the plates). A high-temperature side passage 321 and a low-temperature side passage 322 having narrow gaps formed between two adjacent heat transfer plates 311 and 312 are alternately provided in separation with the heat transfer plate 311 or 312. The high-temperature fluid (the second coolant of the present invention) entered from an inlet 301 of the high-temperature side passage is passed through the high-temperature side passage 321, and discharged from an outlet 302 of the high-temperature side passage. On the other hand, the low-temperature fluid (the third cooling medium of the present invention) entered from an inlet 303 of the low-temperature side passage is passed through the low-temperature side passage 322, and discharged from an outlet 304 of the low-temperature side passage. The plate heat exchanger in this configuration exchanges heat between the high-temperature fluid and the low-temperature fluid in a full countercurrent. Thus, the plate heat exchanger is of high performance and extremely high thermal efficiency, and is small-sized and lightweight, and has a small installation volume, which are advantages.

FIG. 4 is another example of a first heat exchanger 600 to which a micro channel heat exchanger is applied. The micro channel heat exchanger is configured in which a plurality of metal plates is laid on each other for integration. The metal plate includes a group of a large number of micro passages arrayed in the width direction. The micro passages only have to be channels in a rectangular cross section, for example. The dimensions of the height of and the width are preferably one millimeter or less. Various projections or grooves may be provided on the inner surface of the channel. In groups of adjacent micro passages 421 and 422, the first group of micro passages 421 forms the high-temperature side passage, and the second group of micro passages 422 forms the low-temperature side passage. The high-temperature side passage and the low-temperature side passage are alternately provided in separation with the wall 423 of the metal plate. The high-temperature fluid (the second coolant of the present invention) entered from an inlet 401 of the high-temperature side passage is passed through the high-temperature side passage 421, and discharged from an outlet 402 of the high-temperature side passage. On the other hand, the low-temperature fluid (the third cooling medium of the present invention) entered from an inlet 403 of the low-temperature side passage is passed through the low-temperature side passage 422, and discharged from an outlet 404 of the low-temperature side passage. In these flows, the high-temperature fluid and the low-temperature fluid flow in directions opposed to each other in separation with the wall 423 of the metal plate. The micro channel heat exchanger in this configuration also exchanges heat between the high-temperature fluid and the low-temperature fluid in a full countercurrent. Thus, the micro channel heat exchanger is of high performance and extremely high thermal efficiency, and is small-sized and lightweight, and has a small installation volume, which are advantages similar to the plate heat exchanger described above.

In the present invention, similarly to the first coolant, for the third cooling medium, a hydrofluoroether (HFE) compound can be preferably used, which is known as Novec 7000 having a boiling point of 34 °C, Novec 7100 having a boiling point of 61 °C, Novec 7200 having a boiling point of 76 °C, and Novec 7300 having a boiling point of 98 °C. Novec 700, Novec 7100, Novec 7200, and Novec 7300 are trade names of 3M Company. Novec is the trademark of 3M Company. Hereinafter, the same meaning is applied. However, the material of the third cooling medium is not limited to these materials. However, in accordance with the present invention, importance is to select, for the third cooling medium, a cooling medium having the boiling point T₃ equal to the boiling point T₂ of the second coolant 13 or lower than the boiling point T₂ of the second coolant 13. For an example, in the case of using "Fluorinert FC-40" having a boiling point of 155 °C or "Fluorinert FC-43" having a boiling point of 174 °C for the second coolant 11, "Novec 7000" having a boiling point of 34 °C or "Novec 7100" having a boiling point of 61 °C can be preferably used for the third cooling medium.

As illustrated in FIGS. 1 and 5, the cooling system 10 according to the embodiment preferably further has a second heat exchanger 24 placed on the outside of the cooling bath 12. The inlet 223 and the outlet 224 of the low-temperature side passage on the first heat exchanger 22 are coupled to the second heat exchanger 24 through a first circulation path 26. The coupling is configured in which the third cooling medium is passed through the first circulation path 26 to circulate between the first heat exchanger 22 and the second heat exchanger 24. The second heat exchanger 24 only has to be a heat exchanger that cools the third cooling medium moving from the first heat exchanger 22 to the second heat exchanger 24. For example, the second heat exchanger 24 only has to be various heat exchangers (so-called radiators, chillers, cooling towers, and any other devices) including air cooling, water cooling, or evaporative condensers. For example, in the case of using "Novec 7000" having a boiling point of 34 °C for the third cooling medium, the liquid cooling medium removes heat from the second coolant at the first heat exchanger 22, and changes to a gaseous cooling medium. The gaseous cooling medium discharged from the outlet 224 of the low-temperature side passage on the first heat exchanger 22 is passed through the first circulation path 26, entered to the second heat exchanger 24, and cooled here for liquefaction (condensation). The liquid cooling medium is passed through the first circulation path 26, and entered to the inlet 223 of the low-temperature side passage on the first heat exchanger 22. Thus, heat having been removed from the second coolant 13 is efficiently transported from the first heat exchanger 22 to the second heat exchanger 24.

Referring to FIGS. 1 and 5, the cooling system 10 according to the embodiment has a pump 40 configured to pressurize and deliver the second coolant 13 warmed in the cooling bath 12 to the inlet 221 of the high-temperature side passage on the first heat exchanger 22. The pump 40 only has to be a small-sized pump configured to pressurize and deliver the cooling medium against a pressure drop in the first heat exchanger 22. The cooling system 10 may further have a third heat exchanger 90 that is placed on the outside of the cooling bath 12 for cooling the second coolant 13. In this case, the inlet 16 and the outlet 18 of the cooling bath 12, the pump 40, the inlet 221 and the outlet 222 of the high-temperature side passage on the first heat exchanger 22, and the third heat exchanger 90 are coupled to each other via a second circulation path 30. Note that, a flow regulating valve 50 configured to regulate the flow rate of the second coolant 13 passed through the second circulation path 30 and a flow meter 70 are also provided in the second circulation path 30.

The pump 40 preferably includes a function to move a liquid with a relatively large kinematic viscosity (a kinematic viscosity of more than 3 cSt at an ambient temperature of 25 °C). This is because in the case in which Fluorinert FC-43 or FC-40 is used for the second coolant 13, for example, the kinematic viscosity of FC-43 is in a range of about 2.5 to 2.8 cSt, and the kinematic viscosity of FC-40 is in a range of about 1.8 to 2.2 cSt. The flow regulating valve 50 may be a valve that is manually operated. Additionally, the flow regulating valve 50 only has to be a valve that includes an adjustment mechanism for constantly keeping a flow rate based on the measurement value of the flow meter 70. On the other hand, the third heat exchanger 90 is used in combination of a refrigerator, which is a vapor compression refrigerator, for example, in which preferably, heat at a temperature lower than the atmospheric temperature generated by the refrigerator is moved from the low-temperature side to the high-temperature side for cooling the second coolant 13 at the high-temperature side. However, this is merely an example, and the third heat exchanger is not limited to this example. In the third heat exchanger, the refrigerator does not necessarily have to be operated all the time in the operation of the cooling system 10. For example, a configuration is possible in which a temperature sensor installed in the outdoors monitors the atmospheric temperature and the refrigerator is operated only when the atmospheric temperature is higher than the boiling point of the third cooling medium (e.g. Novec 7000 having a boiling point of 34 °C). Thus, the operation is possible in which when the atmospheric temperature is the boiling point of the third cooling medium or less, the refrigerator on the third heat exchanger 90 is stopped, whereas when the atmospheric temperature is higher than the boiling point of the third cooling medium, the refrigerator is operated for forced cooling to support cooling in the first heat exchanger 22, achieving the effect of reducing power consumption.

Next, the operation of the cooling system 10 according to the embodiment will be described. After the operation of the electronic device 100 is started, when the surface temperature of the processor 110 is increased and reached at a temperature higher than the boiling point of the first coolant 11 (e.g. a temperature of 34 °C in Novec 7000), the first coolant 11 enclosed in the closed container 210 of the boiling cooling device 200 begins to evaporate in bubbles from the surface of the inner wall of the heat receiving part 211 of the closed container 210. The vaporized first coolant 11 goes upwards in the space of the heat dissipating part 212 of the closed container 210. However, the temperature of the second coolant 13 (e.g. Fluorinert FC-43) around the boiling cooling device 200 and the electronic device 100 is kept low at a temperature in a range of 17 to 23 °C, for example. Thus, the vaporized first coolant 11 is condensed on the surface of the inner wall of the heat dissipating part 212 of the closed container 210. The first coolant 11 moves on the surface of the inner wall toward the heat receiving part 211 in a liquid phase state, and drops due to gravity. The boiling cooling device 200 locally and strongly removes heat from the processor 110 due to the circulation of the cooling medium between the gaseous phase and the liquid phase in the boiling cooling device 200. At the same time, the second coolant 13 around the boiling cooling device 200 completely removes the heat from the boiling cooling device 200 (mainly through the heat dissipation member 220). Thus, the overall electronic device is cooled. In the cooling, the second coolant 13 having a high boiling point effectively and strongly cools peripheral electronic components (not shown) mounted on the board 120 of the electronic device 100. That is, the cooling medium for secondary cooling (the second coolant 13) used for boiling cooling of the processor 110, which is a major heat generating source, also functions as a cooling medium for effective primary cooling of the peripheral electronic components (not shown). In the first heat exchanger 22, heat is conducted from the second coolant 13 passed through the high-temperature side passage to the third cooling medium (e.g. Novec 7000) passed through the low-temperature side passage, and thus heat is efficiently removed from the second coolant 13. In this manner, triple cooling is performed, including the local cooling of the major heat generating source by the boiling cooling device 200, the overall liquid immersion cooling of the boiling cooling device 200 and the peripheral electronic components (not shown) by the cooling medium for secondary cooling (the second coolant 13), and the heat removal of the cooling medium for secondary cooling by the first heat exchanger 22. Consequently, cooling performances for the electronic device 100 can be significantly improved.

A coolant having a relatively high boiling point (e.g. Fluorinert FC-43 or FC-40 has a boiling point of 150 °C or more) can be used for the second coolant 13, and hence the second coolant 13 is less prone to be evaporated, and the cooling bath 12 containing the second coolant 13 may have an unclosed open space. Thus, this eliminates the necessity of providing a complicated, expensive closing structure. Additionally, the first heat exchanger 22 is the plate heat exchanger 500 or the micro channel heat exchanger 600 having the high-temperature side passage formed of a group of narrow gaps or a group of micro passages and the low-temperature side passage formed of a group of narrow gaps or a group of micro passages alternately provided in separation with a wall. The heat exchanger having such a configuration has a pressure drop larger than a pressure drop in a typical heat exchanger (e.g. a multitubular heat exchanger including a shell-and-tube heat exchanger), whereas the heat exchanger can obtain high heat transfer performance in a compact size. That is, with the provision of the first heat exchanger 22 in a small size and the pump 40 in a small size configured to pressurize and deliver the cooling medium against a pressure drop in the first heat exchanger 22, the heat exchange between the third cooling medium and the cooling medium for secondary cooling (the second coolant 13) enables effective heat removal of the cooling medium for secondary cooling, and the volume occupied by a minimum necessary amount of components is small. Accordingly, the simplification and downsizing of the cooling system are achieved. The first heat exchanger 22 is a small-sized heat exchanger that passes the cooling medium through the passage formed of a group of narrow gaps or a group of micro passages. Thus, a large amount of an expensive cooling medium is unnecessary, and a reduction in cost is enabled. Furthermore, in the previously existing boiling cooling system, mechanisms, such as complicated tubes and a large-sized heat sink, are required for cooling the processor that is a major heat generating source. The presence of these mechanisms inevitably interferes with cooling the peripheral electronic components that have to rely on air cooling. Contrary to the previously existing techniques, in accordance with the present invention, complicated tubes and a large-sized heat sink are eliminated, which is advantageous for cooling the peripheral electronic components (not shown). Moreover, the cooling medium for secondary cooling (the second coolant 13) is distributed throughout the board 120 of the electronic device 100. Thus, the peripheral electronic components (not shown) can be cooled highly efficiently. Note that, in the embodiment, the first coolant 11 for use in the boiling cooling device 200, a coolant having the boiling point T₁ equal to the boiling point T₂ of the second coolant 13 is used, and/or for the third cooling medium for use in heat transfer from the first heat exchanger 22 to the second heat exchanger 24, a coolant having the boiling point equal to the boiling point T₂ of the second coolant 13 is used. The use of these coolants of course also enables the achievement of the aim to greatly improve the cooling efficiency of the previously existing cooling system.

In accordance with a test calculation relating to the downsizing of the system, supposing that under an environment at atmospheric temperature, which is to be 25 °C, a heat of 32 kW generated by an electronic device is transported to the outside by the first heat exchanger, it was found that when a finned tube heat exchanger is used, the heat exchanger has a size of 99 cm X 99 cm X 98 cm and a necessary volume of about 960,000 cm³, whereas when a plate heat exchanger is used, the heat exchanger has a size of 30 cm X 50 cm X 40 cm and a necessary volume of about 60,000 cm³. That is, in accordance with the present invention, the volume necessary to install the first heat exchanger can be reduced to about 1/16 of the previously existing heat exchanger. Accordingly, also in the case in which the first heat exchanger is placed in the inside of the cooling bath 12, for example, the merits obtained from the downsizing of the system is not impaired.

In the cooling system 10 according to the embodiment illustrated in FIGS. 1 and 5, an example is described in which the first heat exchanger 22 is placed in the inside of the cooling bath 12. However, a configuration may be provided in which the first heat exchanger 22 is placed in the outside of the cooling bath 12. FIG. 6 illustrates a cooling system 700 according to an exemplary modification of the embodiment. Components similar to ones of the cooling system 10 illustrated in FIG. 5 are designated similar reference signs, and the detailed description is omitted. In the cooling system 700 according to this exemplary modification, the area to install the first heat exchanger 22 is of curse small.

As described above, the cooling system according to the embodiment is described based on an example in which a unit of an electronic device is accommodated in the cooling bath with reference to FIGS. 1 to 6. However, this is a simplified example for describing the main components of the present invention, which is a non-limiting example. The present invention is of course applicable to a high-density cooling system in which a plurality of units of electronic devices is accommodated in a cooling bath in high density for cooling. In the following, referring to FIGS. 7 to 9, the configuration of a high-density cooling system according to another embodiment of the present invention will be described. Note that, components similar to ones of the cooling system according to the embodiment and the cooling system according to the exemplary modification shown in FIG. 1, 5, and 6 are designated similar reference signs, and the detailed description is omitted.

In the description of another embodiment, the configuration of a high-density cooling system will be described. In the high-density cooling system, 16 units, as electronic devices, in total are accommodated in the accommodating sections of the cooling bath for cooling, each unit including a board having a plurality of processors mounted. Note that, these are only examples. The number of processors per board and a type (a CPU or GPU) of processor can be any numbers and any types. The number of units of electronic devices in the high-density cooling system can also be any numbers. These do not limit the configuration of the electronic device according to the present invention.

Referring to FIGS. 7 to 9, a cooling system 800 according to another embodiment has a cooling bath 12, and an open space 10a is formed by a bottom plate 12a and side walls 12b of the cooling bath 12. In the cooling bath 12, with the provision of vertical inner barrier plates 13a, 13b, 13c, 13d, and 13e and lateral inner barrier plates 14a, 14b, 14c, 14d, and 14e, the open space 10a is equally divided into 16 sections to form an array of 16 accommodating sections 15aa, 15ab, 15ac, 15ad, 15ba, 15bb, 15bc, 15bd, 15ca, 15cb, 15cc, 15cd, 15da, 15db, 15dc, and 15dd (in the following, these 16 accommodating sections are sometimes collectively written in "the accommodating sections 15aa to 15dd"). At least one electronic device 100 is then accommodated in each of the accommodating sections. The open space 10a of the cooling bath 12 includes a second coolant 13 to a liquid level 19. On the bottom parts of the accommodating sections 15aa, 15ab, 15ac, 15ad, 15ba, 15bb, 15bc, 15bd, 15ca, 15cb, 15cc, 15cd, 15da, 15db, 15dc, and 15dd, inflow openings 16aa, 16ab, 16ac, 16ad, 16ba, 16bb, 16bc, 16bd, 16ca, 16cb, 16cc, 16cd, 16da, 16db, 16dc, and 16dd for the second coolant 13 are formed (in the following, these inflow openings are sometimes collectively written in "the inflow openings 16aa to 16dd").

Near the liquid level 19 of the second coolant 13 circulating the accommodating sections 15aa to 15dd, outflow openings 17aa, 17ab, 17ac, 17ad, 17ae, 17ba, 17bb, 17bc, 17bd, 17be, 17ca, 17cb, 17cc, 17cd, 17ce, 17da, 17db, 17dc, 17d d, 17de, 17ea, 17eb, 17ec, 17ed, and 17ee are formed (in the following, these outflow openings are sometimes collectively written in "the outflow openings 17aa to 17ee").

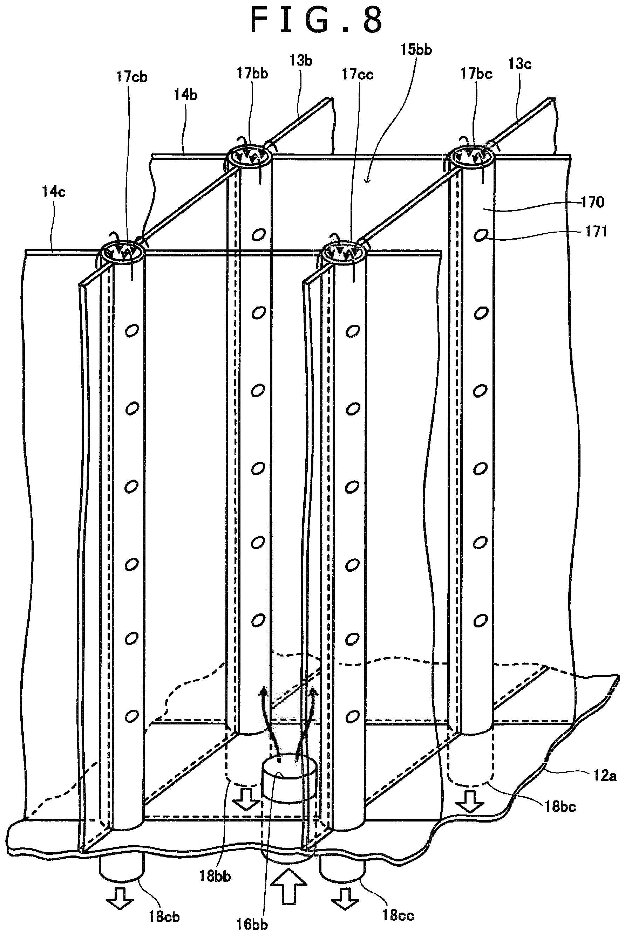

In the cooling system 800 according to another embodiment, the outflow openings are formed at locations at which the plurality of inner barrier plates forming the accommodating sections intersects with each other or near the locations. For example, referring to FIG. 7, the accommodating section 15aa is formed by the vertical inner barrier plates 13a and 13b and the lateral inner barrier plates 14a and 14b. The outflow openings 17aa, 17ba, 17ab, and 17bb are formed, respectively located at the point at which the inner barrier plate 13a intersects with the inner barrier plate 14a, the point at which the inner barrier plate 13a intersects with the inner barrier plate 14b, the point at which the inner barrier plate 13b intersects with the inner barrier plate 14a, and the point at which the inner barrier plate 13b intersects with the inner barrier plate 14b. Similarly, referring to FIG. 8, the accommodating section 15bb is formed by the vertical inner barrier plates 13b and 13c and the lateral inner barrier plates 14b and 14c. The outflow openings 17bb, 17cb, 17bc, and 17cc are formed, respectively located at the point at which the inner barrier plate 13b intersects with the inner barrier plate 14b, the point at which the inner barrier plate 13b intersects with the inner barrier plate 14c, the point at which the inner barrier plate 13c intersects with the inner barrier plate 14b, and the point at which the inner barrier plate 13c intersects with the inner barrier plate 14c.

In the cooling system 800 according to another embodiment, the outflow opening is formed at one end of a discharge pipe 170 that penetrates the bottom plate 12a of the cooling bath 12 and extends to the area near the liquid level 19. For example, referring to FIG. 8, with regard to the accommodating section 15bb, the outflow openings 17bb, 17cb, 17bc, and 17cc are formed by the vertical inner barrier plates 13b and 13c and the lateral inner barrier plates 14b and 14c. The outflow openings 17bb, 17cb, 17bc, and 17cc are respectively formed at one ends of the discharge pipes 170 located at the point at which the inner barrier plate 13b intersects with the inner barrier plate 14b, the point at which the inner barrier plate 13b intersects with the inner barrier plate 14c, the point at which the inner barrier plate 13c intersects with the inner barrier plate 14b, and the point at which the inner barrier plate 13c intersects with the inner barrier plate 14c. Note that, at the other ends of the discharge pipes, bottom openings 18aa, 18ab, 18ac, 18ad, 18ae, 18ba, 18bb, 18bc, 18bd, 18be, 18ca, 18cb, 18cc, 18cd, 18ce, 18da, 18db, 18dc, 18dd, 18de, 18ea, 18eb, 18ec, 18ed, and 18ee are formed (in the following, these bottom openings are sometimes collectively written in "the bottom opening 18aa to 18ee").

In the case in which the outflow opening is formed at locations at which the plurality of inner barrier plates forming the accommodating sections intersects with each other, this is advantageous because the outflow openings provided on the accommodating sections can be secured, distributed at four corners of the accommodating sections. For example, at the accommodating section 15bb, the outflow opening 17bb, 17bc, 17cb, and 17cc are formed by the discharge pipes 170 disposed at its four corners. Note that, in the case in which the outflow openings are formed in this manner, one outflow opening can be a shared outflow opening for the plurality of accommodating sections. For example, the outflow opening 17bb is a part of the outflow opening of the accommodating section 15aa, and at the same time, the outflow opening 17bb is a part of the outflow opening of the accommodating sections 15ab, 15ba, and 15bb. The similar meaning is also applied to the outflow openings 17bc, 17cb, and 17cc. However, with regard to the accommodating sections, the locations where the discharge pipe is provided and the number of the discharge pipes are options. Of course, a discharge pipe or a plurality of discharge pipes may be provided near the locations at which the plurality of inner barrier plates forming the accommodating sections intersects with each other. The discharge pipe does not necessarily have to be integrated with the inner barrier plates. The discharge pipe may be a pipe disposed apart form the inner barrier plates.

As illustrated in FIG. 8, the discharge pipe 170 is may be formed with at least one small hole 171 in the longitudinal direction of the discharge pipe 170. These small holes 171 promote the circulation of the second coolant 13 in the midway point in the depth direction of the accommodating section. On the other hand, the inflow openings 16aa to 16dd do not necessarily have to be tubular openings as illustrated in FIG. 8. For example, the inflow openings may be formed with a large number of nozzles by coupling a header having the plurality of nozzles to one end of a tube.

In the accommodating sections 15aa to 15dd, the electronic device 100 is accommodated, and immersed in the second coolant 13. The electronic device 100 is similar to the electronic device of the embodiment above, and the detailed description here is omitted.

The cooling bath 12 includes the second coolant 13 in the amount enough to immerse the entire electronic device 100 to the liquid level 19. The second coolant 13 is similar to the second coolant of the embodiment above, and the detailed description here is omitted.

The cooling bath 12 is provided with an inlet 16 configured to distribute the second coolant 13 to the inflow openings 16aa to 16dd respectively provided on the accommodating sections 15aa to 15dd through a distributing pipe (not shown), and an outlet 18 configured to collect the second coolant 13 having been passed through the outflow openings 17aa to 17ee of the accommodating sections 15aa to 15dd through a collecting pipe (not shown).

In order to continuously circulate the second coolant 13 cooled at a desired temperature through the inside of the accommodating sections 15aa to 15dd for keeping the electronic devices 100 that are accommodated in the accommodating sections 15aa to 15dd at a predetermined temperature or less during operation, a second circulation path is preferably configured in which the second coolant 13 discharged from the outlet 18 of the cooling bath 12 is cooled at the third heat exchanger and the cooled coolant is returned to the inlet 16 of the cooling bath 12. Examples of such a circulation path and accompanying facilities are already described in detail with reference to FIGS. 5 and 6, and the description here is omitted.

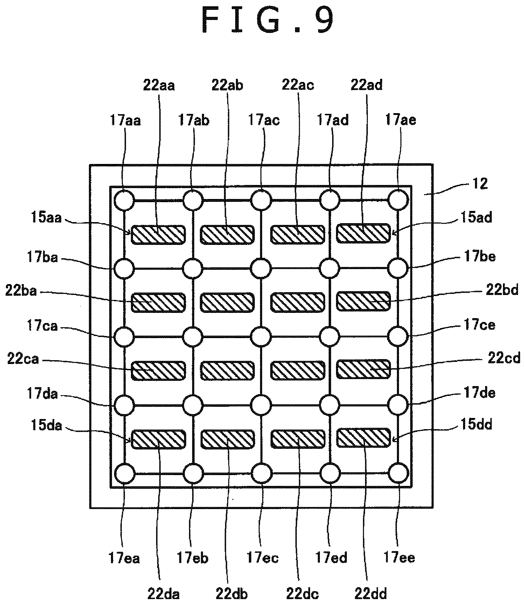

Referring to FIG. 9, the cooling system 800 according to another embodiment has distributed first heat exchangers 22aa, 22ab, 22ac, 22ad, 22ba, 22bb, 22bc, 22bd, 22ca, 22cb, 22cc, 22cd, 22da, 22db, 22dc, and 22dd (in the following, these distributed first heat exchangers are sometimes collectively written in "the distributed first heat exchangers 22aa to 22dd") . The distributed first heat exchangers 22aa to 22dd are respectively disposed on the upper parts of the accommodating sections 15aa to 15dd. The distributed first heat exchangers 22aa to 22dd only have to be mechanically held on a top plate (not shown) similarly to the first heat exchanger according to the embodiment. The distributed first heat exchangers 22aa to 22dd each have the inlet and the outlet of a high-temperature side passage and the inlet and the outlet of a low-temperature side passage similarly to the examples illustrated in FIGS. 1 and 5. The inlet and the outlet of the low-temperature side passage may be coupled to a second heat exchanger placed on the outside of the cooling bath 12 through a first circulation path (not shown). The coupling may be any one method below: a method in which second heat exchangers in the same number as the number of the distributed first heat exchangers 22aa to 22dd are prepared and individually coupled; a method in which the distributed first heat exchangers 22aa to 22dd are divided into a plurality of groups (e.g. four groups) each including some heat exchangers (e.g. four heat exchangers) and second heat exchangers in the same number as the number of the groups are prepared and individually coupled; or a method in which one second heat exchanger is coupled to all of the individual distributed first heat exchangers 22aa to 22dd. The inlet and the outlet of the high-temperature side passage may be coupled to a pump (not shown) and to the inlet and the outlet of the cooling bath through the second circulation path (not shown).

Next, the operation of the cooling system 800 according to another embodiment will be described. The second coolant 13 entered from the inlet 16 is distributed toward the inflow openings 16aa to 16dd formed on the bottom parts of the accommodating sections 15aa to 15dd through a distributing pipe, not shown. The second coolant 13 is blown up from the inflow openings 16aa to 16dd to directly cool the boiling cooling device 200 and peripheral electronic components (not shown) that are mounted on the board 120 of the electronic device 100 and thermally connected to the processor. For example, after blown up from the inflow opening 16bb, the second coolant 13 goes up toward the liquid level 19 while removing heat from the surfaces of the boiling cooling device 200 and the peripheral electronic components (not shown) thermally connected to the processor, and further moves toward the outflow openings 17bb, 17bc, 17cb, and 17cc. In this process, the volume of each of the accommodating sections 15aa to 15dd is as small as about 1/16 of the volume of the open space 10a of the cooling bath 12, and the width of the electronic device 100 to be accommodated in the accommodating section is as small as about 1/4 of the width of the cooling bath 12 as well. Thus, the cooling efficiency of the electronic device 100 by the second coolant 13 is significantly excellent, and the residence of the second coolant 13 around the electronic device 100 can be effectively prevented.

Additionally, in the accommodating sections 15aa to 15dd, the distributed first heat exchangers 22aa to 22dd efficiently remove heat from the second coolant 13. In this manner, triple cooling is performed, including the local cooling of the major heat generating source by the boiling cooling device 200, the liquid immersion cooling of the boiling cooling device 200 and the peripheral electronic components (not shown) by the cooling medium for secondary cooling (the second coolant 13), and the heat removal of the cooling medium for secondary cooling by the distributed first heat exchangers 22aa to 22dd.

In another embodiment described above, an example is described in which the inflow openings are formed on the bottom parts of the accommodating sections. However, the inflow openings may be formed on the side surfaces of the accommodating sections.

In accordance with the high-density cooling system according to another embodiment described above, the electronic device having a width (e.g. about 1/2, 1/3, and 1/4) shorter than the width of the previously existing electronic device is accommodated in the accommodating section having a volume about 1/4 of the volume of the open space of the cooling bath or a volume smaller than about 1/4 of the volume of the open space (e.g. about 1/9 of the volume of the open space when the open space is split into three-by-three sections, 1/12 when the open space is split into three-by-four sections, or 1/16 when the open space is split into four-by-four sections), and the coolant is circulated through the individual accommodating section. Thus, this enables efficient cooling of a plurality of individual electronic devices. That is, in the high-density cooling system according to another embodiment, the warmed coolant is enabled to flow out of the center part of the cooling bath as well. Thus, the avoidance of a problem of the previously existing technique to cause the warmed coolant to flow out of the side surfaces of the cooling bath is enabled. The problem is that the coolant stays near the center of the cooling bath to cause differences in the cooling performance depending on the locations where electronic devices are accommodated in the cooling bath. Accordingly, the cooling performances of a plurality of electronic devices are improved, variations in the cooling performances are eliminated, and stabilization is achieved. The downsizing of the electronic device to be accommodated in the accommodating section is enabled, and thus the improvement of ease of handling and ease of maintenance of the electronic device is achieved.

In the high-density cooling system 800 according to another embodiment illustrated in FIGS. 7 to 9, an example is described in which the distributed first heat exchangers 22aa to 22dd are used. However, similarly to the cooling system 10 according to the embodiment shown in FIGS. 1 and 5, one first heat exchanger and one second heat exchanger may be used for one cooling bath 12. The location where one first heat exchanger 22 is installed is an option. Similarly to the cooling system 10 according to the embodiment and the exemplary modification illustrated in FIGS. 1, 5, and 6, the first heat exchanger 22 may be disposed above or below the liquid level 19 in the inside of the cooling bath 12, or the first heat exchanger 22 may be disposed on the outside of the cooling bath 12. In the case of using one first heat exchanger and one second heat exchanger, the minimization of the numbers of pipes configuring the first circulation path and the second circulation path is achieved, and the simplification of the configuration of the secondary cooling system is also achieved.

In the foregoing embodiment, its exemplary modification, and another the embodiment, the processor mounted on the board of the electronic device 100 may include a CPU, a GPU, or a CPU and a GPU. The processor may include a high speed storage, a chip set, a network unit, a PCI Express bus, a bus switch unit, an SSD, and a power unit (an alternating current-to-direct current converter, a direct current-to-direct current voltage converter, and any other convertor), not shown. The electronic device 100 may be an electronic device, such as a storage device like a server including a blade server, a router, and an SSD. However, as already described, in another embodiment, of course, the electronic device 100 only has to be an electronic device having a width (e.g. about 1/2, 1/3, and 1/4) shorter than the width of a previously existing one.

In the foregoing embodiment, its exemplary modification, and another embodiment, for the closed container 210 of the boiling cooling device 200, an example of a container in a tall, thin box shape is shown. This container may be used in such a manner that the container is placed as a horizontally-long box. The heat receiving part and the heat dissipating part of the closed container 210 are separately described on the upper half and the lower half of the closed container 210 in a tall box shape, for convenience. The heat receiving part and the heat dissipating part may be combined together vertically. In this case, the face thermally connected to the heat generating surface of the processor 110 is the heat receiving part.

In the foregoing embodiment, its exemplary modification, and another embodiment, an example is described in which the boiling cooling device 200 is thermally connected to the processor that is a major heat generating component included in the electronic device 100. However, the present invention does not require all the heat generating components included in the electronic device to be individually thermally connected to the boiling cooling devices. In the case in which the electronic device is a device, such as a storage device like a server including a blade server, a router, and an SSD, the present invention does not require the overall electronic device, as a heat generating component, to be thermally connected to one or a plurality of the boiling cooling devices. A person skilled in the art may freely decide ways to thermally connect the boiling cooling device to which one of heat generating components in a plurality of heat generating components included in the electronic device, or ways to thermally connect the overall electronic device, as one heat generating component, to one or a plurality of boiling cooling devices, depending on structures, characteristics, use states, and any other conditions of the electronic device.

### Industrial Applicability

The present invention is widely applicable to cooling systems that efficiently cools electronic devices.

### Reference Signs List

10, 700, 800: cooling system
100: electronic device
110: processor
111: die (chip)
112: heat spreader
120: board
200, 300, 400: boiling cooling device
210: closed container
211: heat receiving part
212: heat dissipating part
220: heat dissipation the member (the heat radiating fin)
10a: open space
11: first coolant
12a: bottom plate
12b: side wall
13: second coolant
13b, 13c, 13d, 13e: inner barrier plate
14b, 14c, 14d, and 14e: inner barrier plate
15aa, 15ab, 15ac, 15ad, 15ba, 15bb, 15bc, 15bd, 15ca, 15cb, 15cc, 15cd, 15da, 15db, 15dc, and 15dd: accommodating section
16: inlet
16aa, 16ab, 16ac, 16ad, 16ba, 16bb, 16bc, 16bd, 16ca, 16cb, 16cc, 16cd, 16da, 16db, 16dC, 16dd: inflow opening
17aa, 17ab, 17ac, 17ad, 17ae, 17ba, 17bb, 17bc, 17bd, 17be, 17ca, 17cb, 17cc, 17cd, 17ce, 17da, 17db, 17dc, 17dd, 17de, 117eb, 17ec, 17ed, 17ee: outflow opening
170: discharge pipe
171: small hole
18: outlet
18aa, 18ab, 18ac, 18ad, 18ae, 18ba, 18bb, 18bc, 18bd, 18be, 18ca, 18cb, 18cc, 18dd, 18ce, 18da, 18db, 18dc, 18dd, 18de, 18ea, 18eb, 18ec, 18ed, 18ee: bottom opening
19: liquid level
20: top plate
21: coolant guide plate
22, 500, 600: first heat exchanger
22aa, 22ab, 22ac, 22ad, 22ba, 22bb, 22b 22bd, 22ca, 22cb, 22cc, 22cd, 22da, 22db, 22dc, 22dd: distributed first heat exchanger
311, 312: heat transfer plate
321, 421: high-temperature side passage
322, 422: low-temperature side passage
221, 301, 401: high-temperature side passage inlet
222, 302, 402: high-temperature side passage outlet
223, 303, 403: low-temperature side passage inlet
224, 304, 404: low-temperature side passage outlet
423: metal plate wall
24: second heat exchanger
26: first circulation path
30: second circulation path
40: pump
50: flow regulating valve
70: flow meter
90: third heat exchanger

## Claims

1. A cooling system that immerses an electronic device in a coolant for directly cooling the electronic device, the system comprising:
a boiling cooling device thermally connected to at least one heat generating component of an electronic device, the boiling cooling device enclosing a first coolant having a boiling point T₁;
a cooling bath containing a second coolant having a boiling point T₂ (T₂ = T₁ or T₂ > T₁) equal to the boiling point T₁ of the first coolant or higher than the boiling point T₁ of the first coolant, the boiling cooling device and the electronic device being immersed in the second coolant and directly cooled in the cooling bath;
a first heat exchanger having a high-temperature side passage and a low-temperature side passage alternately provided in separation with a wall, the high-temperature side passage being formed of a group of narrow gaps or a group of micro passages, the high-temperature side passage through which the second coolant is passed, the low-temperature side passage being formed of a group of narrow gaps or a group of micro passages, the low-temperature side passage through which a third cooling medium is passed, the third cooling medium having a boiling point T₃ (T₃ = T₂ or T₃ < T₂) equal to the boiling point T₂ of the second coolant or lower than the boiling point T₂ of the second coolant, the first heat exchanger being configured to conduct heat from the second coolant to the third cooling medium, and
a pump configured to pressurize and deliver the second coolant warmed in the cooling bath toward an inlet of the high-temperature side passage on the first heat exchanger.

2. The cooling system according to claim 1,
wherein: the boiling cooling device includes
a closed container having a heat receiving part and a heat dissipating part and
a heat dissipation member provided on the heat dissipating part, and
when the boiling cooling device and the electronic device are immersed in the second coolant, the boiling cooling device is thermally connected to the heat generating component so that the heat dissipating part is located above the heat receiving part.

3. The cooling system according to claim 1 or 2,
wherein: the boiling point of the first coolant is a temperature of 100 °C or less;
the boiling point of the second coolant is a temperature of 150 °C or more, and
the boiling point of the third cooling medium is a temperature of 50 °C or less.

4. The cooling system according to claim 3,
wherein the first coolant and/or the third cooling medium includes a fluorocarbon compound as a main component.

5. The cooling system according to claim 3,
wherein the second coolant includes a fully fluorinated compound as a main component.

6. The cooling system according to claim 1,
wherein the first heat exchanger is a plate heat exchanger or a micro channel heat exchanger.

7. The cooling system according to claim 1, further comprising a second heat exchanger disposed on an outside of the cooling bath, the second heat exchanger being configured to cool the third cooling medium,
wherein an inlet and an outlet of the low-temperature side passage on the first heat exchanger are coupled to the second heat exchanger through a first circulation path.

8. The cooling system according to claim 1 further comprising a third heat exchanger disposed on an outside of the cooling bath, the third heat exchanger being configured to cool the second coolant,
wherein an inlet and an outlet of the second coolant of the cooling bath, the inlet and an outlet of the high-temperature side passage on the first heat exchanger, the pump, and the third heat exchanger are coupled to each other through a second circulation path.

9. The cooling system according to claim 1,
wherein the cooling bath has a top plate detachably or openably mounted on the upper area of cooling bath opening, and
the top plate is configured to hold the first heat exchanger.

10. A cooling system that immerses a plurality of electronic devices in a coolant for directly cooling the plurality of electronic devices, the system comprising:
a cooling bath having an open space formed by a bottom plate and side walls;
a plurality of accommodating sections in an array formed by dividing the open space with a plurality of inner barrier plates provided in the cooling bath, the accommodating section being configured to accommodate at least one electronic device; and
an inflow opening and an outflow opening for a coolant, the inflow opening and the outflow opening being formed on each of the plurality of accommodating sections, the inflow opening being formed on a bottom part or a side surface of each of the accommodating sections, the outflow opening being formed near a liquid level of the coolant circulating the accommodating sections,
wherein: the cooling system further comprises
a boiling cooling device thermally connected to at least one heat generating component of an electronic device, the boiling cooling device enclosing a first coolant having a boiling point T₁,
a first heat exchanger having a high-temperature side passage and a low-temperature side passage alternately provided in separation with a wall, the high-temperature side passage being formed of a group of narrow gaps or a group of micro passages, the high-temperature side passage through which a second coolant is passed, the second coolant having a boiling point T₂ (T₂ = T₁ or T₂ > T₁) equal to the boiling point T₁ of the first coolant or higher than the boiling point T₁ of the first coolant, the low-temperature side passage being formed of a group of narrow gaps or a group of micro passages, the low-temperature side passage through which a third cooling medium is passed, the third cooling medium having a boiling point T₃ (T₃ = T₂ or T₃ < T₂) equal to the boiling point T₂ of the second coolant or lower than the boiling point T₂ of the second coolant, the first heat exchanger being configured to conduct heat from the second coolant to the third cooling medium, and
a pump configured to pressurize and deliver the second coolant warmed in the cooling bath toward an inlet of the high-temperature side passage on the first heat exchanger; and
in each of the plurality of accommodating sections, the boiling cooling device and the at least one electronic device are immersed in the second coolant in the accommodating sections for directly cooling the boiling cooling device and the at least one electronic device.
